(19) **Europäisches Patentamt**
**European Patent Office**
**Office européen des brevets**

(11) **EP 4 600 606 A1**

(12) **EUROPEAN PATENT APPLICATION**

(43) Date of publication:
**13.08.2025 Bulletin 2025/33**

(21) Application number: **25154620.6**

(22) Date of filing: **29.01.2025**

(51) International Patent Classification (IPC):
**G01C 19/574** (2012.01)    **B81B 3/00** (2006.01)

(52) Cooperative Patent Classification (CPC):
**G01C 19/574; B81B 3/0018; B81B 3/0059; B81B 3/0062; B81B 3/0097**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.02.2024 IT 202400002890**

(71) Applicant: **STMicroelectronics International N.V.**
**1228 Plan-les-Ouates, Geneva (CH)**

(72) Inventors:
• **FEDELI, Patrick**
  **20030 SENAGO (MI) (IT)**
• **FALORNI, Luca Giuseppe**
  **20812 LIMBIATE (MB) (IT)**
• **GATTERE, Gabriele**
  **21040 CASTRONNO (VA) (IT)**

(74) Representative: **Studio Torta S.p.A.**
**Via Viotti, 9**
**10121 Torino (IT)**

(54) **MICROELECTROMECHANICAL GYROSCOPE WITH FULLY DIFFERENTIAL STRUCTURE AND PITCH/ROLL SENSING**

(57)    A microelectromechanical gyroscope includes: a support body (2) having a main surface (2a) parallel to a reference plane (XY) defined by a first axis (X) and a second axis (Y) perpendicular to each other; transduction masses (3a, 3b), constrained to the support body (2) so as to be capable of oscillating along a driving direction ($D_D$) parallel to the first axis (X) and along a third axis (Z) perpendicular to the first axis (X) and the second axis (Y); sensing masses (5a-5d), constrained to the support body (2) at a distance from the substrate (7) so as to be capable of oscillating in a direction parallel to the second axis (Y); and motion conversion flexures (25) connecting the transduction masses (3a, 3b) to respective sensing masses (5a-5d) and configured so as to convert movements of the transduction masses (3a, 3b) along the third axis (Z) into movements of the respective sensing masses (5a-5d) along the second axis (Y).

FIG. 2

**EP 4 600 606 A1**

## Description

Technical field

The present invention relates to a microelectromechanical gyroscope with fully differential structure and pitch/roll sensing.

Background

As is known, in the field of microelectromechanical gyroscopes, the design of the devices needs to face increasingly stringent market demands, for example as to the increase in scale factor stability and vibration rejection performance. Applications where scale factor stability and vibration rejection are particularly important include those relating to autonomous inertial navigation for the automotive sector. The scale factor defines the sensitivity of the gyroscope and should be stable during the life of the sensor. However, external factors such as variations in temperature (also during the production step due to soldering on printed circuit board - PCB) or humidity and mechanical stress may affect the scale factor and, consequently, the accuracy of the measurements.

In a MEMS gyroscope, the scale factor is directly correlated to the distance at rest between fixed or stator sensing electrodes and movable sensing electrodes. If the support body deforms, the distance at rest between fixed and movable sensing electrodes is altered and variations affect the sensitivity of the sensor.

A known solution to the scale factor stability issue envisages a fully differential sensing architecture that compensates for sensitivity variation. In a fully differential architecture, in fact, each movable sensing electrode is differentially coupled to two respective fixed sensing electrodes. This allows the pairs of fixed sensing electrodes to be placed at a short distance from the movable sensing electrode respectively associated, so as to reduce the effects of deformations of the support body. The rejection of common-mode contributions may thus be improved, and the differential contributions may thus be amplified.

This solution is easily practicable in gyroscopes that sense rotations around a yaw axis perpendicular to the support body and have a typically in-plane-type sensing structure. Gyroscopes that sense rotations around roll or pitch axes, instead, have an out-of-plane-type sensing structure and the available fully differential architectures may be less satisfactory in some respects. For the same silicon area occupied, in particular, the out-of-plane sensing structures have lower sensitivity with respect to in-plane sensing structures, because the sensing electrodes substantially develop in planes parallel to the main face of the support body. Conversely, in-plane sensing structures may generally also exploit the development of the sensing electrodes in a direction perpendicular to the support body. Furthermore, in-plane-type sensing structures still have fixed sensing electrodes that are on average closer and are therefore less subject to the effects of deformations of the support body, as already observed.

US 2018/306580 A1 discloses a microelectromechanical gyroscope comprising a support body having a main surface parallel to a reference plane defined by a first axis and a second axis perpendicular to each other; and transduction masses, constrained to the support body so as to be capable of oscillating along a driving direction parallel to the first axis and along a third axis perpendicular to the first axis and the second axis. Sensing masses are constrained to the support body at a distance from the substrate so as to be capable of oscillating in a direction parallel to the second axis. Flexures connect the transduction masses to respective sensing masses.

Other examples of known gyroscopes are described in EP 3 872 451 A1 and EP 4 105 167 A1.

Summary

It is therefore an aim of the present invention to provide a microelectromechanical gyroscope which allows the limitations described to be overcome or at least mitigated.

According to the present invention, a microelectromechanical gyroscope is provided as defined in claim 1.

Brief Description of the Figures

For a better understanding of the present invention, preferred embodiments are presented, by way of non-limiting example, with reference to the attached drawings, wherein:

- Figure 1 is a block diagram of a microelectromechanical gyroscope in accordance with an embodiment of the present invention;
- Figure 2 is a top-plan view of a microstructure of the gyroscope of Figure 1;
- Figure 3 is a cross-section of the microstructure of Figure 2, taken along the line III-III of Figure 2, in a first operating configuration;
- Figure 4 shows the view of Figure 3, with the microstructure in a second operating configuration;
- Figure 5 is a top-plan view of an enlarged detail of the microstructure of Figure 2;
- Figure 6 is a partial perspective view of the detail of Figure 5;
- Figures 7a-7c are respectively a first, a second and a third cross-section of the detail of Figure 5 in the first operating configuration; and
- Figures 8a-8c show the views respectively of Figures 7a-7c in the second operating configuration.

Description of Embodiments

The following description refers to the arrangement shown in the drawings; consequently, expressions such as "above", "below", "upper", "lower", "top", "bottom", "right", "left" and the like relate to the attached Figures and are not to be interpreted in a limiting manner.

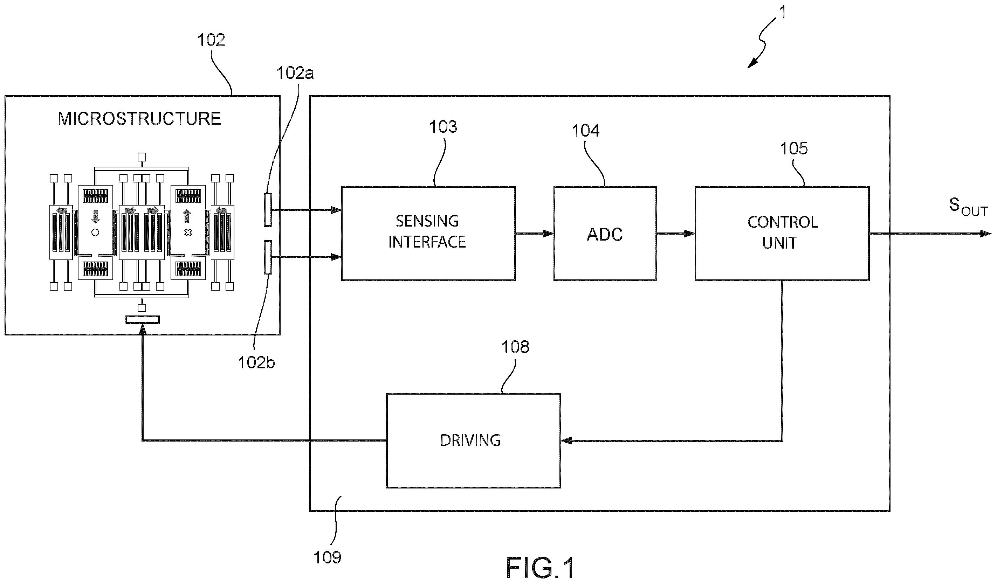

With reference to Figure 1, a microelectromechanical gyroscope in accordance with an embodiment of the present invention is indicated as a whole by the numeral 1 and comprises a microstructure 102, a sensing interface 103, an analog-to-digital converter 104, a control unit 105 and a driving stage 108. The sensing interface 103, the analog-to-digital converter 104, the control unit 105 and the driving stage 108 may be components of a dedicated integrated circuit or ASIC (Application Specific Integrated Circuit) 109 coupled to the microstructure 102.

The sensing interface 103 receives sensing signals from a first sensing terminal 102a and a second sensing terminal 102b of the microstructure 2, respectively, and provides amplified sensing signals, usable by the analog-to-digital converter 104 to generate digital sensing signals.

The control unit 105 processes the digital sensing signals and provides an output signal $S_{OUT}$ indicative of an angular velocity around a sensing axis (not shown), measured through the microstructure 102.

The driving stage 108 is controlled by the control unit 105 and provides a driving voltage $V_D$ to maintain movable portions of the microstructure 102 oscillating with a driving frequency $\omega_D$ that is constant and close to a resonance frequency of the same microstructure 102.

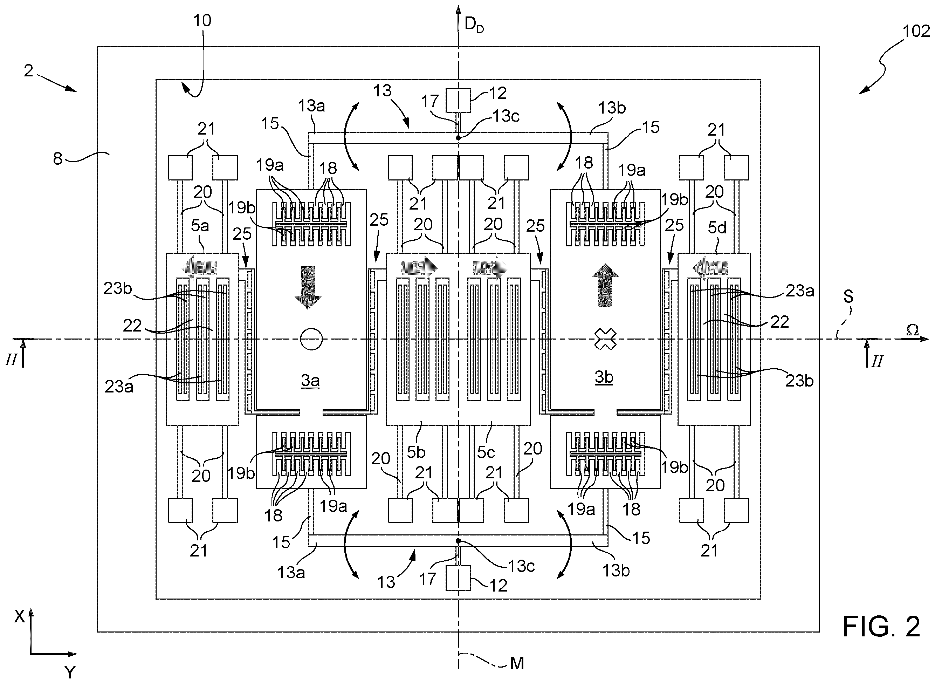

With reference to Figures 2-4, the microstructure 102 comprises a support body 2, transduction masses 3a, 3b and sensing masses 5a-5d, movable with respect to the support body 2.

The support body 2 has a main surface 2a parallel to a plane XY defined by a first axis X and a second axis Y of a set of three Cartesian axes and perpendicular to a third axis Z of the set of three. The support body 2 may comprise, for example, a substrate 7 and a frame structure 8, formed on the substrate 7 and laterally delimiting a cavity 10 where the transduction masses 3a, 3b and the sensing masses 5a-5d are accommodated. The cavity 10 is also delimited at the bottom by the substrate 7. The substrate 7 and the frame structure 8 are of semiconductor material, for example respectively monocrystalline and polycrystalline silicon.

The transduction masses 3a, 3b and the sensing masses 5a-5d, also of semiconductor material, are elastically connected to the support body 2 so as to be capable of oscillating in accordance with respective predetermined degrees of freedom with respect to a reference axis M, which is parallel to the first axis X (and therefore to the main surface 2a of the support body 2) and perpendicular to a sensing axis S. The sensing axis S is a median axis of the transduction masses 3a, 3b (in rest conditions) and is parallel to the second axis Y.

In detail, the transduction masses comprise a first transduction mass 3a and a second transduction mass 3b arranged symmetrically opposite, in rest conditions, with respect to the reference axis M. The first transduction mass 3a and the second transduction mass 3b are suspended at a distance from the substrate 7 and are supported by anchors 12 and two oscillating arms 13 so as to be movable with respect to the support body along a driving direction $D_D$ parallel to the first axis X and along a transduction direction $D_T$ parallel to the third axis Z. In one embodiment, in particular, the anchors 12 are placed along the reference axis M and are symmetrically opposite to the sensing axis S. The oscillating arms 13, having an elongated shape in the direction of the second axis Y, are also arranged symmetrically opposite with respect to the sensing axis S and each have a first end 13a, a second end 13b and a fulcrum 13c. The first ends 13a and the second ends 13b of the oscillating arms 13 are connected to the first transduction mass 3a and the second transduction mass 3b, respectively, by suspension flexures 15 configured to convey movements from the ends 13a, 13b of the oscillating arms 13 to the transduction masses 3a, 3b in the direction of the first axis X. In the direction of the second axis Y, instead, the suspension flexures 15 are almost rigid and the deformations are limited to what is useful to accommodate the movements of the oscillating arms 13. The fulcrums 13c of the oscillating arms 13 are coupled to the respective anchors 12 by suspension flexures 17 and are aligned along the reference axis M in positions symmetrically opposite with respect to the sensing axis S. The suspension flexures 17 are configured so that the oscillating arms 13 may oscillate in the plane XY parallel to the main surface 2a around the respective fulcrums 13a. The suspension flexures 17 instead prevent the translation of the fulcrums 13c in a direction parallel to the first axis X. Consequently, the oscillating arms 13 coordinate and allow the phase-opposition or differential movement of the first transduction mass 3a and the second transduction mass 3b parallel to the first axis X (in practice, discordant displacements of equal amplitude, but in opposite directions along the first axis X). Conversely, in-phase or common-mode movements are prevented (i.e. the oscillating arms 13 prevent the first transduction mass 3a and the second transduction mass 3b from moving simultaneously in a concordant manner in the same direction along the first axis X).

The transduction masses 3a, 3b are also provided with movable sensing electrodes 18, capacitively coupled, for example in comb fingered configuration, to respective groups of fixed driving electrodes 19a, 19b rigidly anchored to the support body 2. In particular, the movable driving electrodes 18 and the fixed driving electrodes 19a, 19b are shaped and coupled so as to apply, in response to the driving voltage $V_D$ provided by the driving stage 108, electrostatic forces to the transduction masses 3a, 3b oriented according to the first axis X, in the driving direction $D_D$. The driving voltage $V_D$ is applied to the first transduction mass 3a and the second transduction mass 3b with opposite polarities, so that the electrostatic forces are also opposite and cause oscillations of the first transduction mass 3a and the second transduction mass 3b at the driving frequency and in phase-opposition. Due to the driving and the degrees of freedom, the transduction masses 3a, 3b transduce rotations around the sensing axis S, which is parallel to the plane XY and perpendicular to the reference axis M, into movements along the transduction direction $D_T$, parallel to the third axis Z. In other words, when the support body 2 rotates around the sensing axis with an angular velocity Q the transduction masses 3a, 3b oscillate along the third axis Z at the driving frequency $\omega_D$ and with an amplitude modulated by the angular velocity Q.

The sensing masses, identical to each other, comprise a first sensing mass 5a and a second sensing mass 5b, coupled to the first transduction mass 3a, and a third sensing mass 5c and a fourth sensing mass 5d, coupled to the second transduction mass 3b. The first sensing mass 5a and the second sensing mass 5b are adjacent to respective opposite sides of the first transduction mass 3a; similarly, the third sensing mass 5c and the fourth sensing mass 5d are adjacent to respective opposite sides of the second transduction mass 3b. In the direction of the second axis Y, therefore, the first transduction mass 3a is interposed between the first sensing mass 5a and the second sensing mass 5b; and the second transduction mass 3b is interposed between the third sensing mass 5c and the fourth sensing mass 5d. The second sensing mass 5b and the third sensing mass 5c are further interposed between the first transduction mass 3a and the second transduction mass 3b and, in one embodiment, form a single rigid body.

The sensing masses 5a-5d are suspended at a distance from the substrate 7 and are supported by respective anchors 20 and suspension flexures 21. In particular, the suspension flexures 21 are yielding in the direction of the second axis Y and substantially rigid in the direction of the first axis X and the third axis Z. As a result, the sensing masses 5a-5d are movable with respect to the support body 2 in the direction parallel to the second axis Y and the sensing axis S.

The sensing masses 5a-5d are provided with movable sensing electrodes 22 capacitively coupled to respective first fixed sensing electrodes 23a and second fixed sensing electrodes 23b, which are rigidly anchored to the support body 2. More precisely, in a non-limiting embodiment the movable sensing electrodes 22 and the fixed sensing electrodes 23a, 23b are defined by plates or flat surfaces perpendicular to the second axis Y and form capacitors having variable capacitance depending on the position of the sensing masses 5a-5d with respect to the second axis Y. Furthermore, the first fixed sensing electrodes 23a and the second fixed sensing electrodes 23b are coupled to the first sensing terminal 102a and the second sensing terminal 102b of the microstructure 102, respectively.

The sensing masses 5a-5d are connected to the respective transduction masses 3a, 3b through motion conversion flexures 25 having skew bending, configured so as to convert the motion of the transduction masses 3a, 3b along the third axis Z into a motion of the sensing masses 5a-5d along the sensing axis S, i.e. in a direction parallel to the second axis Y. The skew bending is a strain to which a body may be subject when the axis of an applied moment does not coincide with a main axis of inertia. In this case, the inflection plane of the body does not coincide with the stress plane. The skew bending may be considered composed of two straight bendings having a moment axis coincident with a main axis of inertia.

The motion conversion flexures 25 have an elongated shape in the direction of the first axis X and each connect a respective transduction mass 3a, 3b and a respective sensing mass 5a-5d. More precisely, the motion conversion flexures 25 have a first end connected to the respective transduction mass 3a, 3b and a second end connected to the respective sensing mass 5a-5d. Furthermore, the motion conversion flexures 25 connecting the first transduction mass 3a to the first sensing mass 5a and to the second sensing mass 5b are symmetrical to each other and are configured to cause movements of the first sensing mass 5a and the second sensing mass 5b in phase-opposition (i.e. of equal amplitude, but in opposite directions along the second axis Y) in response to displacements of the first transduction mass 3a along the third axis Z; similarly, the motion conversion flexures 25 connecting the second transduction mass 3b to the third sensing mass 5c and the fourth sensing mass 5d are symmetrical to each other and are configured to cause movements of the third sensing mass 5c and the fourth sensing mass 5d in phase-opposition in response to movements of the second transduction mass 3b along the third axis Z. Furthermore, the motion conversion flexures 25 which connect the second sensing mass 5b to the first transduction mass 3a and the third sensing mass 5c to the second transduction mass 3b are symmetrical to each other with respect to the reference axis M (in rest conditions).

In detail, in one embodiment the first ends of the motion conversion flexures 25 are coupled to the respective transduction masses 3a, 3b through connection flexures 26, yielding in the direction of the first axis X and rigid in the direction of the second axis Y and the third axis Z. In practice, the connection flexures 26 convey the movement of the transduction masses 3a, 3b along the third axis Z to the first ends of the respective motion conversion flexures 25 in an almost rigid manner. The first ends of the motion conversion flexures 25 therefore follow the movement of the respective transduction masses 3a, 3b along the transduction direction $D_T$ and the third axis Z. The connection flexures 26 instead allow the relative movement of the transduction masses 3a, 3b with respect to the motion conversion flexures 25 along the driving direction $D_D$, parallel to the first axis X. The transduction masses 3a, 3b may therefore oscillate due to the driving along the first axis X without altering the state of the motion conversion flexures 25, while the motion along the third axis Z is conveyed and converted into a corresponding motion along the sensing axis S, in a direction parallel to the second axis Y. Recesses 28 obtained in the sides of the transduction masses 3a, 3b and extending longitudinally in the direction of the second axis Y accommodate part of the connection flexures 26, which may therefore have the desired length and yielding in accordance with the design preferences.

In rest conditions, the first ends of the motion conversion flexures 25 are aligned in a direction parallel to the second axis Y.

Both by arrangement and by action of the motion conversion flexures 25, the sensing masses 5a-5d, the movable sensing electrodes 22 and the fixed sensing electrodes 23a, 23b form a fully differential sensing structure of in-plane type.

For example, the motion conversion flexures 25 may be formed substantially as described in the published patent application EP 3 872 451 A1, in the name of the Applicant. Hereinafter, for simplicity, reference will be made to only one of the motion conversion flexures 25, for example the one connecting the first transduction mass 3a to the first sensing mass 5a, meaning however that what has been stated also applies to all the others.

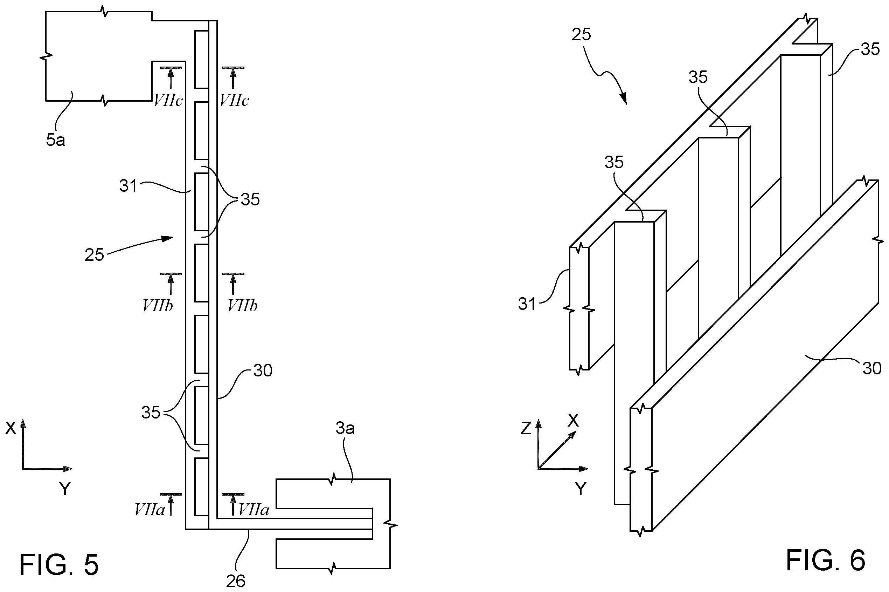

With reference also to Figures 5 and 6, the motion conversion flexure 25 comprises a first elastic body 30, a second elastic body 31 and a plurality of transverse elements 35, all of which are formed for example of the same semiconductor material as the substrate 7 and the frame structure 8 and form a single piece.

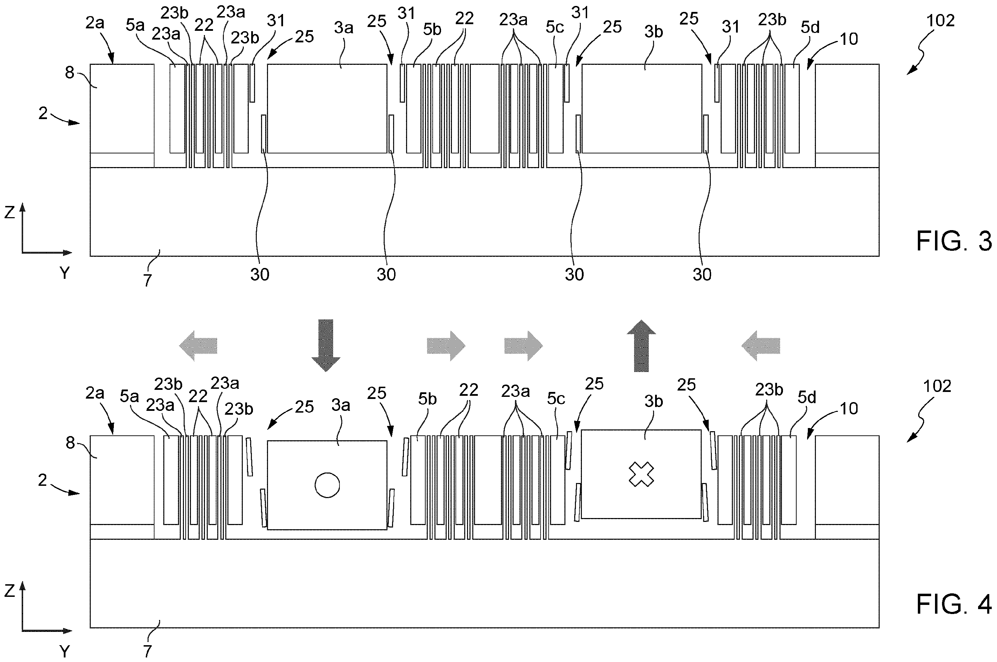

The first elastic body 30 and the second elastic body 31 are defined by flat rectangular plates of the same shape, in rest conditions perpendicular to the second axis Y and elongated in the direction of the first axis X. The first elastic body 30 and the second elastic body 31 are offset with respect to each other both in the direction of the second axis Y and in the direction of the third axis Z. For example, the first elastic body 30 extends adjacent to the respective transduction mass 3a, 3b (for example the first transduction mass 3a, as in Figure 6) and at a greater distance from the respective sensing mass 5a-5d (for example the first sensing mass 5a); vice versa, the second elastic body 31 extends adjacent to the respective sensing mass 5a-5d (here the first sensing mass 5a) and at a greater distance from the respective transduction mass 3a, 3b (here the first transduction mass 3a). Furthermore, the first elastic body 30 is closer to the substrate 7 than the second elastic body 31 (see also Figure 3). For example, a lower edge of the first elastic body 30 is aligned in rest conditions, to a face of the first transduction mass 3a arranged facing the substrate 7; an upper edge of the second elastic body 31 is aligned with a face of the first sensing mass 5a arranged facing outwards. The first elastic body 30 and the second elastic body 31 have dimension, along the third axis Z, smaller than the transduction masses 3a, 3b and the sensing masses 5a-5d. The first elastic body 30 is connected to the respective connection flexure 26 at the first end of the motion conversion flexure 25; the second elastic body 31 is connected to the respective sensing mass 5a-5d (here the first sensing mass 5a) at the second end of the motion conversion flexure 25.

The transverse elements 35 are defined by flat plates of the same shape, for example rectangular, in rest conditions perpendicular to the first axis X. The elements are uniformly spaced along the first axis X and have first sides connected to the first elastic body 30 and second sides, opposite to the first sides, connected to the second elastic body 31.

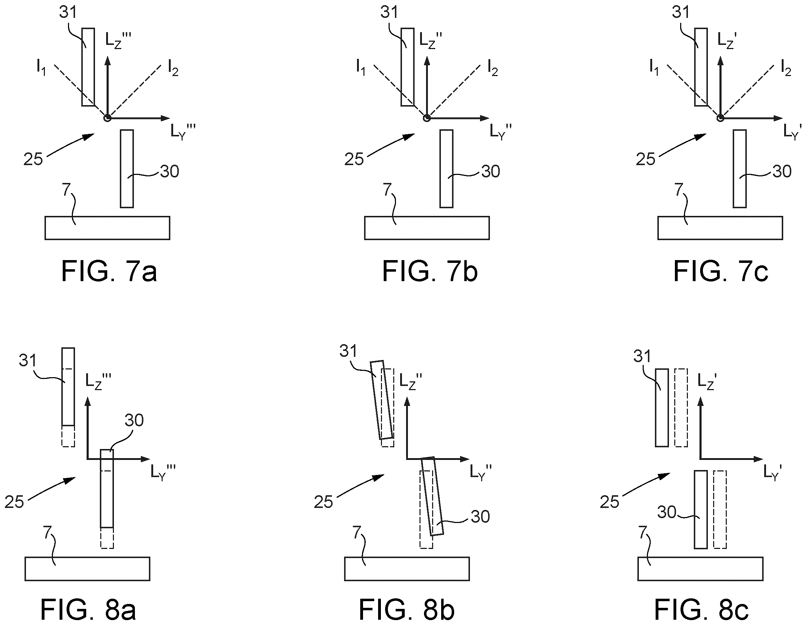

Figures 7a-7c show, by way of example, cross-sections of the motion conversion flexure 25 along planes parallel to the plane YZ at the first end, at a median portion and at the second end, respectively. In each of the Figures 7a-7c the main axes of inertia $I_1$, $I_2$ of the corresponding section of the first motion conversion flexure 25 are also shown, in the hypothesis that this section has infinitesimal thickness. In rest conditions, in particular, the main axes of inertia $I_1$, $I_2$ have a same orientation in each section and are misaligned and transverse with respect to both the second axis Y and the third axis Z. Figures 7a-7c also show, in rest conditions, also pairs of local axes (indicated respectively by Ly'-Lz', Ly"-Lz" and Ly'''-Lz'''), each pair being formed by axes parallel to the second axis Y and the third axis Z, respectively, and passing through the barycenter of the section shown.

For each section of the first motion conversion flexure 25, a centrifugal moment of inertia Ic may be calculated, with respect to the corresponding pair of local axes, through the integral:

$$I_C = \iint r_1 r_2 \, dA$$

where $r_1$ and $r_2$ represent the distance of each point of the section from a first and a second axis of the pair of local axes respectively, while dA is the area unit of the section. The centrifugal moment of inertia Ic is non-zero, since the local axes are not axes of symmetry of the section and therefore do not coincide with the main axes of inertia $I_1$, $I_2$. In particular, the main axes of inertia $I_1$, $I_2$ form an angle $\beta$ with the local axis parallel to the third axis Z and with the local axis parallel to the second axis Y, respectively.

Consequently, as may be seen in Figures 8a-8c, a force applied on the motion conversion flexure 25, for example along the local axis Lz", causes a skew bending of the motion conversion flexure 25. In particular, this force causes a deformation along the local axis Lz", which entails a resulting deformation along the local axis Ly". Compared to the rest positions, represented with a dashed line, in response to a displacement of the first end of the motion conversion flexure 25 along the third axis Z (Figure 7a), the skew bending causes a rototranslation of the median section (Figure 7b) and the translation of the second end in the direction of the second axis Y. Due to the skew bending, the motion along the third axis Z caused by the transduction masses 3a, 3b to the first ends of the motion conversion flexures 25 in response to a rotation around the sensing axis S is converted into a corresponding motion along the second axis Y of the second ends of the motion conversion flexures 25 and therefore of the sensing masses 5a-5d.

The constraints represented by the suspension flexures 17, 21 and by the connection flexures 26 favour the skew bending of the motion conversion flexures 25 and facilitate the correct movement of the sensing masses 5a-5d.

When the support body 2 rotates around the sensing axis S, the transduction masses 3a, 3b oscillate along the transduction direction $D_T$ and the third axis Z at the driving frequency $\omega_D$, in phase-opposition (i.e. in opposite directions) and with amplitude proportional to the angular velocity Q. The motion conversion flexures 25 convert the oscillations of the transduction masses 3a, 3b along the third axis Z into corresponding oscillations of the sensing masses 5a-5d along the second axis Y, which may be read through the capacitive coupling between the movable sensing electrodes 22 and fixed sensing electrodes 23a, 23b. In more detail, the first sensing mass 5a and the second sensing mass 5b oscillate in phase-opposition with each other, as well as the third sensing mass 5c and the fourth sensing mass 5d. Furthermore, the first sensing mass 5a and the fourth sensing mass 5d oscillate in-phase with each other. Similarly, the second sensing mass 5b and the third sensing mass 5c oscillate in-phase with each other both due to the action of the motion conversion flexures 25 and, in addition, obviously due to the fact that they are constrained to each other to form a single rigid body. The movement of the second sensing mass 5b and the third sensing mass 5c would still be in-phase even in the absence of a rigid constraint therebetween.

The gyroscope according to the invention may therefore be used to sense rotations around pitch or roll axes of the support body, in addiction implementing also a fully differential structure in the plane thanks to the conversion of the out-of-plane motion of the transduction masses 3a-3b into the in-plane motion of the sensing masses 5a-5d. The invention therefore allows the advantages of fully differential structures to be extended also to gyroscopes wherein the transduction of the rotation originally generates an out-of-plane movement (in fact, when rotations around pitch or roll axes are sensed). In particular, the invention allows to improve the rejection of common-mode contributions and the stability of the scale factor following external events, such as thermal or mechanical stresses, that may deform the substrate.

Finally, it is clear that modifications and variations may be made to the gyroscope described and illustrated herein without thereby departing from the scope of the present invention, as defined in the attached claims.

## Claims

1. A microelectromechanical gyroscope comprising:

   a support body (2) having a main surface (2a) parallel to a reference plane (XY) defined by a first axis (X) and a second axis (Y) perpendicular to each other;
   transduction masses (3a, 3b), constrained to the support body (2) so as to be capable of oscillating along a driving direction ($D_D$) parallel to the first axis (X) and along a third axis (Z) perpendicular to the first axis (X) and the second axis (Y);
   sensing masses (5a-5d), constrained to the support body (2) at a distance from the substrate (7) so as to be capable of oscillating in a direction parallel to the second axis (Y) ;
   motion conversion flexures (25) connecting the transduction masses (3a, 3b) to respective sensing masses (5a-5d) and configured to convert movements of the transduction masses (3a, 3b) along the third axis (Z) into movements of the respective sensing masses (5a-5d) along the second axis (Y).

2. The gyroscope according to claim 1, comprising first fixed sensing electrodes (23a) and second fixed sensing electrodes (23b), rigidly anchored to the support body (2), wherein the sensing masses (5a-5d) are provided with movable sensing electrodes (22) capacitively coupled to respective first fixed sensing electrodes (23a) and second fixed sensing electrodes (23b).

3. The gyroscope according to claim 1 or 2, wherein the transduction masses comprise a first transduction mass (3a) and a second transduction mass (3b) symmetrically opposite, in rest conditions, with respect to a reference axis (M) parallel to the first axis (X).

4. The gyroscope according to claim 3, comprising first anchors (12) fixed to the support body (2) and oscillating arms (13) having respective fulcrums (13c) and supported by the first anchors (12) around the respective fulcrums (13c) so as to oscillate parallel to the reference plane (XY), the fulcrums (13c) being aligned along the reference axis (M) in symmetrically opposite positions with respect to a median axis (S) of the transduction masses (3a, 3b) parallel to the second axis (Y); wherein the first transduction mass (3a) and the second transduction mass (3b) are supported by the oscillating arms (13) so as to be movable parallel to the first axis (X) and parallel to the third axis (Z).

5. The gyroscope according to claim 4, wherein the oscillating arms (13) are coupled to the transduction masses (3a, 3b) so as to allow phase-opposition movements and prevent in-phase movements of the first transduction mass (3a) and the second transduction mass (3b) along the first axis (X).

6. The gyroscope according to claim 4 or 5, wherein the oscillating arms (13) have respective first ends (13a) connected to the first transduction mass (3a) and respective second ends (13b) connected to the second transduction mass (3b) through respective first suspension flexures (15) configured to convey movements from the first ends (13a) and second ends (13b) of the oscillating arms (13) to the first transduction mass (3a) and the second transduction mass (3b) in the direction of the first axis (X).

7. The gyroscope according to any of claims 4 to 6, comprising second anchors (20) and second suspension flexures (21); wherein the sensing masses (5a-5d) are supported by respective ones of the second anchors (20) and second suspension flexures (21) and wherein the second suspension flexures (21) are yielding in the direction of the second axis (Y) and rigid in the direction of the first axis (X) and the third axis (Z).

8. The gyroscope according to any of claims 3 to 7, wherein the sensing masses (5a-5d) comprise a first sensing mass (5a) and a second sensing mass (5b), coupled to the first transduction mass (3a), and a third sensing mass (5c) and a fourth sensing mass (5d), coupled to the second transduction mass (3b); wherein the first sensing mass (5a) and the second sensing mass (5b) are adjacent to respective opposite sides of the first transduction mass (3a) and the third sensing mass (5c) and the fourth sensing mass (5d) are adjacent to respective opposite sides of the second transduction mass (3b).

9. The gyroscope according to claim 8, wherein the second sensing mass (5b) and the third sensing mass (5c) form a single rigid body.

10. The gyroscope according to claim 8 or 9, wherein the motion conversion flexures (25) connecting the first transduction mass (3a) to the first sensing mass (5a) and the second sensing mass (5b) are configured to cause movements of the first sensing mass (5a) and the second sensing mass (5b) in phase-opposition in response to displacements of the first transduction mass (3a) along the third axis (Z); and wherein the motion conversion flexures (25) connecting the second transduction mass (3b) to the third sensing mass (5c) and the fourth sensing mass (5d) are symmetrical to each other and are configured to cause movements of the third sensing mass (5c) and the fourth sensing mass (5d) in phase-opposition in response to displacements of the second transduction mass (3b) along the third axis (Z).

11. The gyroscope according to any of claims 8 to 10, wherein the motion conversion flexures (25) have an elongated shape in the direction of the first axis (X) and each have a first end connected to a respective one of the transduction masses (3a, 3b) and a second end connected to a respective one of the sensing masses (5a-5d).

12. The gyroscope according to claim 11, wherein the first ends of the motion conversion flexures (25) are coupled to the respective transduction masses (3a, 3b) through connection flexures (26) rigid along the third axis (Z) and yielding along the driving direction ($D_D$), parallel to the first axis (X).

13. The gyroscope according to any of the preceding claims, wherein the motion conversion flexures (25) are of a skew bending type.

14. The gyroscope according to any of the preceding claims, wherein each motion conversion flexure (25) comprises a first elastic body (30), a second elastic body (31) and a plurality of transverse elements (35); and wherein, in each motion conversion flexure (25):

the first elastic body (30) and the second elastic body (31) are defined by flat rectangular plates, in rest conditions perpendicular to the second axis (Y) and elongated in the direction of the first axis (X); and
the first elastic body (30) and the second elastic body (31) are offset with respect to each other in the direction of the second axis (Y) and in the direction of the third axis (Z).

15. The gyroscope according to claim 14 dependent on claim 11, wherein, in each motion conversion flexure (25):

the first elastic body (30) is connected to the respective transduction mass (3a, 3b) at the first end of the motion conversion flexure (25); and
the second elastic body (31) is connected to the respective sensing mass (5a-5d) at the second end of the motion conversion flexure (25).

16. The gyroscope according to claim 14 or 15, wherein the transverse elements (35) are defined by flat plates in rest conditions perpendicular to the first axis (X), are uniformly spaced along the first axis (X) and have first sides connected to the first elastic body (30) and second sides, opposite to the first sides, connected to the second elastic body (31).

FIG.1

EP 4 600 606 A1

FIG. 2

EP 4 600 606 A1

FIG. 3

FIG. 4

EP 4 600 606 A1

FIG. 5

FIG. 6

FIG. 7a  FIG. 7b  FIG. 7c

FIG. 8a  FIG. 8b  FIG. 8c

EP 4 600 606 A1

Europäisches
Patentamt

European
Patent Office

Office européen
des brevets

# EUROPEAN SEARCH REPORT

**Application Number**

EP 25 15 4620

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2018/306580 A1 (GATTERE GABRIELE [IT] ET AL) 25 October 2018 (2018-10-25) * paragraphs [0048], [0050] - [0052], [0075], [0078], [0079], [0081], [0085], [0094]; figure 1 * | 1-16 | INV. G01C19/574 B81B3/00 |
| A,D | EP 3 872 451 A1 (ST MICROELECTRONICS SRL [IT]) 1 September 2021 (2021-09-01) * paragraph [0072] * | 1-16 | |
| A | EP 4 105 167 A1 (ST MICROELECTRONICS SRL [IT]) 21 December 2022 (2022-12-21) * paragraph [0128] * | 1-16 | |

TECHNICAL FIELDS
SEARCHED      (IPC)

G01C
B82B
B81B

The present search report has been drawn up for all claims

| Place of search | Date of completion of the search | Examiner |
|---|---|---|
| The Hague | 2 June 2025 | Rocca, Simone |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 4620

This annex lists the patent family members relating to the patent documents cited in the above-mentioned European search report.
The members are as contained in the European Patent Office EDP file on
The European Patent Office is in no way liable for these particulars which are merely given for the purpose of information.

02-06-2025

| Patent document cited in search report | | Publication date | Patent family member(s) | | Publication date |
|---|---|---|---|---|---|
| US 2018306580 | A1 | 25-10-2018 | NONE | | |
| EP 3872451 | A1 | 01-09-2021 | CN | 113375635 A | 10-09-2021 |
| | | | CN | 214747920 U | 16-11-2021 |
| | | | EP | 3872451 A1 | 01-09-2021 |
| | | | IT | 202000003868 A1 | 25-08-2021 |
| | | | US | 2021261403 A1 | 26-08-2021 |
| EP 4105167 | A1 | 21-12-2022 | CN | 115480389 A | 16-12-2022 |
| | | | CN | 218181211 U | 30-12-2022 |
| | | | EP | 4105167 A1 | 21-12-2022 |
| | | | US | 2022380199 A1 | 01-12-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018306580 A1
- EP 3872451 A1

- EP 4105167 A1